# EUROPEAN PATENT APPLICATION

(11) **EP 4 293 378 A1**
(43) Date of publication of application: **20.12.2023**
(21) Application number: 22178565.2
(22) Date of filing: 13.06.2022
(51) Int. Cl.: G01R 33/54, G06N 3/04, G06N 3/08

(54) **GENERATION OF MAGNETIC RESONANCE FINGERPRINTING PULSE SEQUENCES**

(71) Applicant: Koninklijke Philips N.V., 5656 AG Eindhoven (NL)
(72) Inventor: FORTHMANN, Peter, Eindhoven (NL); AMTHOR, Thomas Erik, Eindhoven (NL)
(74) Representative: Philips Intellectual Property & Standards

(57) **Abstract**

Disclosed herein is a medical system (100, 300). The execution of machine executable instructions (120) causes a computational system (104) to repeatedly: generate (200) the random input vector; receive (202) a generated MRF pulse sequence (128) in response to inputting the random input vector into a GAN generator neural network (122); and append (204) the generated MRF pulse sequence to an MRF pulse sequence database (130). Execution of the machine executable instructions causes the computational system to: input (208) each generated MRF pulse sequence in the MRF pulse sequence database into a trained scoring algorithm (124) to assign the one or more score values to each generated MRF pulse sequence; and receive (210) a selected MRF pulse sequence (136) from the MRF pulse sequence database by applying a predetermined criterion (134) to the one or more score values of each generated MRF pulse sequence in the MRF pulse sequence database.

## Description

### FIELD OF THE INVENTION

The invention relates to magnetic resonance imaging, in particular to magnetic resonance fingerprinting.

### BACKGROUND OF THE INVENTION

Magnetic Resonance Fingerprinting (MRF) is a technique where a number of RF pulses, distributed in time, are applied such that they cause signals from different materials or tissues to have a unique contribution to the measured MR signal. The signal depends not only on the physical parameters of the tissue (T1, T2, etc.,), but also on parameters of the magnetic fields, such as B0 and B1. These are encoded in various combinations, leading to possibly tens or even hundreds of thousands of entries in a magnetic resonance fingerprinting dictionary.

In most applications, MRF is used to determine highly resolved quantitative maps of T1, T2, or other physical tissue parameters. The optimization of the sequence becomes important, because one needs to make sure that small changes in T1, T2, or other parameters are uniquely reflected in measurable changes of the signal shape.

The journal publication Hamilton, Jesse I., and Nicole Seiberlich. "Machine learning for rapid magnetic resonance fingerprinting tissue property quantification." Proceedings of the IEEE 108.1 (2019): 69-85 discloses that Magnetic resonance fingerprinting (MRF) is a magnetic resonance imaging (MRI)-based method that can provide quantitative maps of multiple tissue properties simultaneously from a single rapid acquisition. Tissue property maps are generated by matching the complex signal evolutions collected at the scanner to a dictionary of signals derived using the Bloch equation simulations. It further discloses that in some circumstances, the process of dictionary generation and signal matching can be time-consuming, reducing the utility of this technique. Recently, several groups have proposed using machine learning to accelerate the extraction of quantitative maps from the MRF data. This article provides overview of research that combines MRF and machine learning, as well as present original research demonstrating how machine learning can speed up dictionary generation for cardiac MRF (cMRF) .

### SUMMARY OF THE INVENTION

The invention provides for a medical system, a computer program, and a method in the independent claims. Embodiments are given in the dependent claims.

The above-mentioned article by Hamilton et. al. notes the time-consuming process of generating a dictionary for MRF. Generating the pulse sequences for performing MRF can also be time consuming. One may need to repeatedly modify an MRF pulse sequence and then calculate its effectiveness using Bloch simulations. It can be computationally intensive to perform an optimization of an MRF pulse sequence. Embodiments may provide a means of more rapidly generating an MRF pulse sequence. A Generative Adversarial Network (GAN) may be trained to generate suitable MRF pulse sequences. The GAN is formed by a GAN generator neural network and a GAN discriminator pair. The pair is trained together with the GAN discriminator being trained to discriminate between authentic and fake MRF pulse sequences. In this context, the GAN discriminator is trained to recognize MRF pulse sequences that provide for good information encoding capability. The GAN generator neural network is trained to produce a generated MRF pulse sequence in response to receiving a random input vector. The dimensionality of the random input vector can be chosen. The GAN generator neural network is trained such that the generated MRF pulse sequence is able to fool the GAN discriminator. This achieves eventually the increase the GAN discriminator to improve its capability to identify suitable MRF pulse sequences.

Embodiments of the invention also comprise a trained scoring algorithm that is trained to output one or more score values in response to receiving an MRF pulse sequence. The trained scoring algorithm takes the place of using a Bloch simulator to evaluate the effectiveness of a particular MRF pulse sequence.

To produce a new MRF pulse sequence, the random input vector is repeatedly generated and input into the GAN generator neural network. This may be used to produce a large number of generated MRF pulse sequences. These for example may be stored in a file folder or a MRF pulse sequence database. As used herein a database is a system for storing and retrieving data. This may range from a relational database to a system for locating stored files.

The trained scoring algorithm is then used to screen the MRF pulse sequence database. Each generated MRF pulse sequence can be input into the trained scoring algorithm to obtain one or more score values which may be compared against a predetermined criterion. For example, the one or more score values could be calculated as a generated pulse sequence is stored in the MRF pulse sequence database, or the one or more score value could be calculated on the fly when searching for a selected MRF pulse sequence.

The advantage of generating a selected MRF pulse sequence in this manner is that it may be extremely fast. The GAN generator neural network can produce a large number of generated MRF pulse sequences very fast, and the trained scoring algorithm may be used screen the MRF pulse sequence database rapidly. It could for example enable generation of MRF pulse sequences on the fly or on demand.

A hybrid approach may also be used. For example, the trained scoring algorithm could be used to identify a subset of the MRF pulse sequences from the MRF pulse sequence database that meet a screening criterion. Numerically calculated score values may then be calculated for members of the subset of MRF pulse sequences to select the MRF pulse sequence that best matches the need specified by the screening criterion. The numerically calculated score values may be calculated using a Bloch simulator. The advantage of this scheme is that the number of numerical simulations is greatly reduced.

In one aspect the invention provides for a medical system. The medical system comprises a memory that stores several things. The memory stores machine-executable instructions, a GAN generator neural network, and a trained scoring algorithm. The GAN generator neural network is configured to output a generated magnetic resonance fingerprinting (MRF) pulse sequence in response to receiving a random input vector. The trained scoring algorithm is configured to output one or more score values in response to receiving the generated MRF pulse sequence as input.

The medical system further comprises a computational system. The execution of the machine-executable instructions causes the computational system to repeatedly generate the random input vector. Execution of the machine-executable instructions further causes the computational system to repeatedly receive the generated MRF pulse sequence in response to inputting the random input vector into the GAN generator neural network.

Execution of the machine-executable instructions further causes the computational system to repeatedly append the generated MRF pulse sequence to an MRF pulse sequence database. In response to receiving a random input vector the GAN generator neural network outputs a valid or generated MRF pulse sequence. Normally it is very computationally intensive to construct a highly optimized MRF pulse sequence. By having a GAN trained to produce them in response to receiving a random input vector a large number of generated MRF pulse sequences can be constructed in a very short period of time. This large number of generated MRF pulse sequences can then be stored in a database system.

Execution of the machine-executable instructions further causes the computational system to input each generated MRF pulse sequence in the MRF pulse sequence database into the trained scoring algorithm to assign the one or more score values to each generated MRF pulse sequence. Execution of the machine-executable instructions further causes the computational system to choose a selected MRF pulse sequence from the MRF pulse sequence database by applying a predetermined criterion to the one or more score values of each generated MRF pulse sequence in the MRF pulse sequence database. The GAN generator neural network may be used to generate a large number of MRF pulse sequences. However, for a particular application or use it may not be apparent which is the best MRF pulse sequence to select from the MRF pulse sequence database.

To perform this in a very rapid manner the trained scoring algorithm outputs the one or more score values when an MRF pulse sequence is input into it. These various score values may have different values relating to different image weightings or aspect of image quality. One can then go through the MRF pulse sequence database and look or compare the one or more score values of each pulse sequence in the MRF pulse sequence database to a predetermined criterion. For example, the predetermined criterion may emphasize one particular image weighting factor such as T1 or T2-^{∗}. In other examples several different factors may be considered simultaneously and a weighting between them may be used. In any case, the use of these two machine learning modules, the GAN generator neural network and the trained scoring algorithm, may enable very rapid selection of the selected MRF pulse sequence from the MRF pulse sequence database.

In another embodiment execution of the machine-executable instructions further causes the computational system to calculate a magnetic resonance fingerprinting (MRF) dictionary with predetermined dictionary entries for the selected MRF pulse sequence by performing a Bloch equation simulation controlled by the selected MRF pulse sequence for each of the predetermined dictionary entries. In this embodiment the MRF dictionary for the selected MRF pulse sequence is prepared. This may be beneficial because in order to obtain useful information from k-space data acquired with the selected MRF pulse sequence an appropriate MRF dictionary may be necessary.

The MR signals in the dictionary can be calculated by modeling the response of each of the substances using the well known Bloch equation to the pulse sequence. These predicted MR signal values can then be compared to the measured MR signals. Each of the substances in the dictionary can potentially make a positive contribution to the measured MR signal. A comparison at all or many measurement times enables an accurate deconvolution of the composition, in terms of the substances in the magnetic resonance fingerprinting dictionary, of the region contributing to the measured magnetic resonance signal.

In another embodiment the medical system further comprises a magnetic resonance imaging system. Execution of the machine-executable instructions further causes the computational system to acquire MRF k-space data by controlling the magnetic resonance imaging system with the selected MRF pulse sequence. Execution of the machine-executable instructions further causes the computational system to reconstruct one or more magnetic resonance fingerprinting images using the MRF k-space data and the MRF dictionary according to a magnetic resonance fingerprinting protocol. This embodiment may be beneficial because the one or more MRF images are reconstructed from the k-space data acquired using the selected MRF pulse sequence and the MRF dictionary that was made custom for it. This may provide for magnetic resonance fingerprinting imaging that has improved quality.

The acquisition of the MRF k-space data may in some examples involve adjustments to the selected MRF pulse sequence. For example, normally the gradients are adjusted to control the field of view.

In another embodiment the GAN generator neural network is further configured to receive one or more control switches as input. The one or more control switches may be values which are put into the input of the GAN generator neural network. Execution of the machine-executable instructions further causes the computational system to receive the one or more control switches. Execution of the machine-executable instructions further causes the computational system to input the one or more control switches into the GAN generator neural network with the random input vector. Execution of the machine-executable instructions further causes the computational system to store the one or more control switches with the generated MRF pulse sequence in the MRF pulse sequence database. The selected MRF pulse sequence is at least partially chosen using the set of chosen control switches.

The control switches may for example be used to specify data about the subject, details about the acquisition, or even an anatomical region. As such this may enable a single GAN neural network to be used for a variety of situations. For example, if different anatomical regions are being imaged one solution would be to have multiple GAN generator neural networks that are specialized. Another solution would be to use the control switches and then during training the control switches are also used so that the GAN generator is more flexible, and its behavior can be controlled and configured.

In another embodiment the one or more control switches comprise an anatomical region.

In another embodiment the one or more control switches comprises a clinical question. The clinical question may for example be a type of examination which is being performed.

In another embodiment the one or more control switches comprises a timing restriction on the acquisition of the k-space data. This may be useful in situations where there is repetitive motion such as a heartbeat or breathing.

In another embodiment the one or more control switches comprise a breath hold duration.

In another embodiment choosing the selected MRF pulse sequence from the MRF pulse sequence database by applying a predetermined criterion to the one or more score values of each generated MRF pulse sequence in the MRF pulse sequence database comprises calculating a composite score using the one or more score values and selecting the generated MRF pulse sequence with the highest composite score. For example, the one or more score values may comprise scores for different things such as T1 weighting, T2 weighting, or the detection of a certain tissue type. The composite score may be a way of balancing all these different factors and using them to select the selected MRF pulse sequence.

In another embodiment execution of the machine-executable instructions further causes the computational system to receive user input. The user input specifies a composition of the composite score. The selected MRF pulse sequence is chosen in response to receiving the user input. For example, there may be a user interface which enables the user to select which components of the one or more score values is important. This may then be used to select the selected MRF pulse sequence.

In another embodiment the choosing of the selected MRF pulse sequence from the MRF pulse sequence database comprises selecting a subset of MRF pulse sequences from the MRF pulse sequence database that meets a screening criterion. The choosing further comprises calculating a set of numerically calculated score values for each of the subset of MRF pulse sequences. The choosing further comprises choosing the selected MRF pulse sequence from the subset of MRF pulse sequences by comparing the predetermined criterion to the set of numerically calculated score values for each of the subset of MRF pulse sequences. The particular MRF pulse sequence can be evaluated by performing simulations. For example, a Bloch simulation can be used to determine how effective the MRF pulse sequence is at providing data which can be used for a T1 weighted image. As the trained scoring algorithm may have limitations because it is a trained or machine learning component numerical determination of the one or more score values can also be performed. For example, the database may have a large number of MRF pulse sequences. The trained scoring algorithm can be used to initially screen and reduce the number of MRF pulse sequences which need to be searched. The MRF pulse sequences identified by the trained scoring algorithm can then be refined by performing numerical calculations of the score values for each of the subset of MRF pulse sequences.

In another embodiment the score values comprise a T1 accuracy score.

In another embodiment the score values comprise a T2 accuracy score.

In another embodiment the score values comprise a T2-star accuracy score.

In another embodiment the one or more score values comprise a proton density accuracy score.

In another embodiment execution of the machine-executable instructions further causes the computational system to receive a training MRF pulse sequence and to train the GAN generator neural network and a GAN discriminator neural network using the training MRF pulse sequence according to a GAN training protocol. In a GAN two different neural network components are trained in conjunction. There is the GAN generator neural network and the GAN discriminator neural network. As was described previously the GAN generator neural network receives a random input vector and it outputs a MRF pulse sequence in response. The GAN discriminator network is trained to identify if an MRF pulse sequence is real or not. The GAN generator network is trained using the GAN discriminator network and alternating with this the GAN discriminator neural network is trained with the training MRF pulse sequence and false or fake MRF pulse sequences generated by the GAN generator neural network.

In another embodiment execution of the machine-executable instructions further causes the computational system to receive a prior MRF pulse sequence. Execution of the machine-executable instructions further causes the computational system to calculate a set of numerically evaluated score values for each of the one or more score values for the prior MRF pulse sequence. This for example may involve setting up a set of Bloch equations and solving for the one or more score values numerically. Execution of the machine-executable instructions further causes the computational system to train the trained scoring algorithm using the prior MRF pulse sequence and the set of numerically evaluated score values. The exact training method will depend upon the type of algorithm or machine learning module used to implement the trained scoring algorithm.

The training of the GAN generator neural network and a GAN discriminator neural network (600) using the training MRF pulse sequence according to a GAN training protocol, and involving training of the scoring algorithm may be done by the medical system the trained scoring algorithm is deployed in for inference. The training may also be carried-out separate or remote form the medical system the trained scoring algorithm is deployed in. Further, a GAN network may be remotely trained as use das in initial trained GAN network deployed in the medical system of the invention, and subsequently the deployed GAN work an especially the trained scoring algorithm may undergo continued training while deployed.

In another embodiment the trained score algorithm is implemented as a decision tree. In another embodiment the trained score algorithm is implemented as a support vector machine.

In another embodiment the trained score algorithm is implemented as a multilayer Perceptron neural network. In another embodiment the trained score algorithm is implemented as a ResNet neural network.

In another embodiment the trained score algorithm is implemented as a convolutional neural network.

In another embodiment the trained score algorithm is implemented as a U-Net neural network.

In another aspect the invention provides for a computer program configured for execution by a computational system. Execution of the machine-executable instructions causes the computational system to repeatedly generate a random input vector. Execution of the machine-executable instructions further causes the computational system to repeatedly receive the generated MRF pulse sequence in response to inputting the random input vector into a GAN generator neural network. The GAN generator neural network is configured to output the generated MRF pulse sequence in response to receiving the random input vector.

Execution of the machine-executable instructions further causes the computational system to append the generated MRF pulse sequence to an MRF pulse sequence database.

Execution of the machine-executable instructions further causes the computational system to input each generated MRF pulse sequence in the MRF pulse sequence database into the training score algorithm to assign the one or more score values to each generated MRF pulse sequence. The trained scoring algorithm is configured to output the one or more score values in response to receiving the generated MRF pulse sequence as input. Execution of the machine-executable instructions further causes the computational system to receive a selected MRF pulse sequence from the MRF pulse sequence database by applying a predetermined criterion to the one or more score values of each generated MRF pulse sequence in the MRF pulse sequence database.

In another aspect the invention provides for a method. The method comprises repeatedly generating a random input vector. The method further comprises repeatedly receiving a generated MRF pulse sequence in response to inputting the random input vector into a GAN generator neural network. The GAN generator neural network is configured to output a generated MRF pulse sequence in response to receiving the random input vector. The method further comprises repeatedly appending the generated MRF pulse sequence to an MRF pulse sequence database.

The method further comprises inputting each generated MRF pulse sequence in the MRF pulse sequence database into a trained scoring algorithm to assign one or more score values to each generated MRF pulse sequence. The trained scoring algorithm is configured to output the one or more score values in response to receiving the generated MRF pulse sequence as input. The method further comprises receiving a selected MRF pulse sequence from the MRF pulse sequence database by applying a predetermined criterion to the one or more score values of each generated MRF pulse sequence in the MRF pulse sequence database.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1;
Fig. 3 illustrates a further example of a medical system;
Fig. 4 shows a flow chart which illustrates a method of using the medical system of Fig. 3;
Fig. 5 shows a flowchart which illustrates the training of the trained scoring algorithm;
Fig. 6 illustrates the training of the GAN generator neural network;
Fig. 7 illustrates one use of the GAN generator neural network;
Fig. 8 illustrates an extension of the trained scoring algorithm; and
Fig. 9 illustrates a modification of the GAN generator neural network.

### DETAILED DESCRIPTION OF EMBODIMENTS

Like numbered elements in these figures are either equivalent elements or perform the same function. Elements which have been discussed previously will not necessarily be discussed in later figures if the function is equivalent.

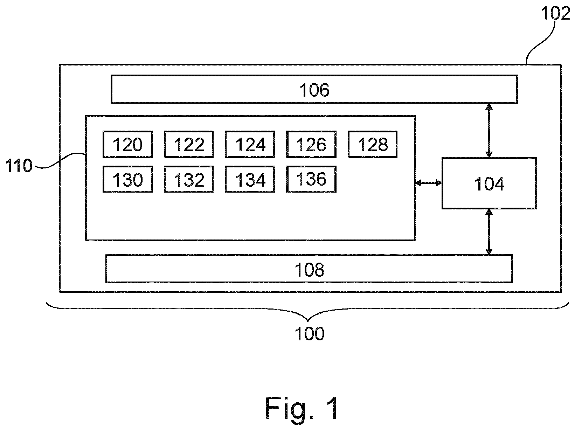

Fig. 1 illustrates an example of a medical system 100. The medical system 100 comprises a computer 102 that has a computational system 104. The computer 102 may represent one or more computers at one or more locations. The computational system 104 may also represent one or more computational systems such as one or more computing cores. The computational system 104 is shown as being in communication with an optional hardware interface 106 and an optional user interface 108. The hardware interface 106 may enable the computational system 104 to communicate and send controls and receive data from other components of the medical system 100 if they exist. The optional user interface 108 may also enable an operator to control and operate the medical system 100.

The computational system 104 is shown as being in further communication with a memory 110. The memory 110 is intended to represent various types of memory which the computational system 104 may have access to. The memory 110 may be a non-transitory storage medium. The memory 110 is shown as containing machine-executable instructions 120. The machine-executable instructions 120 enable the computational system 104 to perform basic tasks such as numerical calculations and/or image processing. The machine-executable instructions 120 may also enable the computational system 104 to control other components or devices via the hardware interface 106. The memory 110 is further shown as containing a GAN generator neural network 122 and a trained scoring algorithm 124. The memory 110 is further shown as containing a random input vector 126 and a generated MRF pulse sequence 128.

The random input vector 126 may be input into the GAN generator neural network 122 to generate or output the generated MRF pulse sequence 128. By generating a large number of random input vectors 126 a large number of generated MRF pulse sequences 128 may be created. The memory 110 is further shown as containing the MRF pulse sequence database 130. For example, a large number of generated MRF pulse sequences 128 can then be stored in the MRF pulse sequence database 130. The memory 110 is further shown as containing one or more score values 132 that were generated for the MRF pulse sequence 128 by inputting the generated MRF pulse sequence 128 into the trained scoring algorithm 124. There may be one or more score values 132 generated for each of the generated MRF pulse sequence 128 in the MRF pulse sequence database 130. This could be done at different times. For example, after the generated MRF pulse sequence 128 is generated by the GAN generator neural network 122 the one or more score values 132 may be generated and then stored at the same time in the MRF pulse sequence database 130. In other examples the one or more score values 132 may be generated on the fly as the MRF pulse sequence database 130 is searched. In both cases there may be a predetermined criterion 134 which is used to select a selected MRF pulse sequence 136 from the MRF pulse sequence database 130. The predetermined criterion 134 may be a means of evaluating the one or more score values 132 for each of the MRF pulse sequence databases 130.

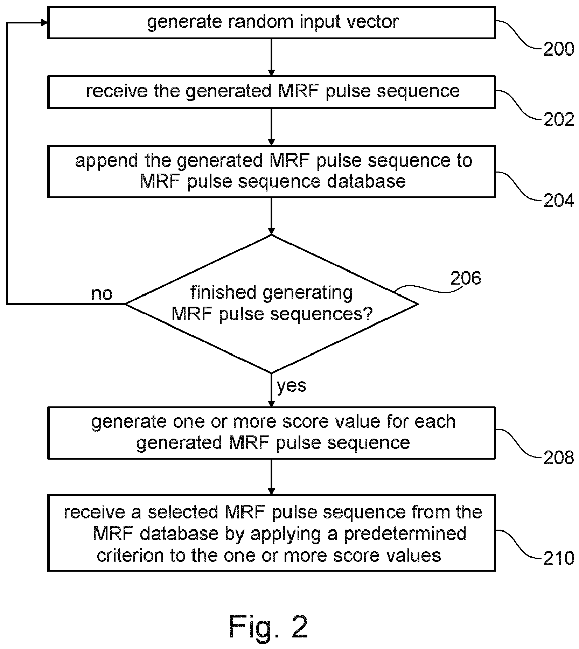

Fig. 2 shows a flowchart which illustrates a method of operating the medical system 100 of Fig. 1. First, in step 200, the random input vector 126 is generated. Next, in step 202, the generated MRF pulse sequence 128 is received in response to inputting the random input vector 126 into the GAN generator neural network 122. In step 204, the generated MRF pulse sequence 128 is appended to the MRF pulse sequence database 130. In this example, the one or more score values 132 have not yet been generated and not yet placed into the MRF pulse sequence database 130. However, at this time, after step 202 has been performed, the generation of the one or more score values 132 for a particular generated MRF pulse sequence 128 may be calculated by inputting the generated MRF pulse sequence 128 into the trained scoring algorithm 124. In this case, when the generated MRF pulse sequence 128 is appended to the MRF pulse sequence database 130 the one or more score values 132 may be stored and associated with the record for this generated MRF pulse sequence 128 at the same time.

The method then proceeds to box 206, which is a decision box. In this case, the question is 'is the algorithm finished generating MRF pulse sequences?'. If the answer is no, then the method proceeds back to step 200 and another random input vector 126 is generated and the process repeats itself. If the answer is yes, then the method proceeds to box 208. In box 208 each generated MRF pulse sequence in the MRF pulse sequence database is input into the trained scoring algorithm to assign the one or more score values each generated MRF pulse sequence. Then finally, in step 210, the selected MRF pulse sequence 136 is received from the MRF pulse sequence database 130 by applying the predetermined criterion to the one or more score values 132 of each generated MRF pulse sequence 128 in the MRF pulse sequence database 130.

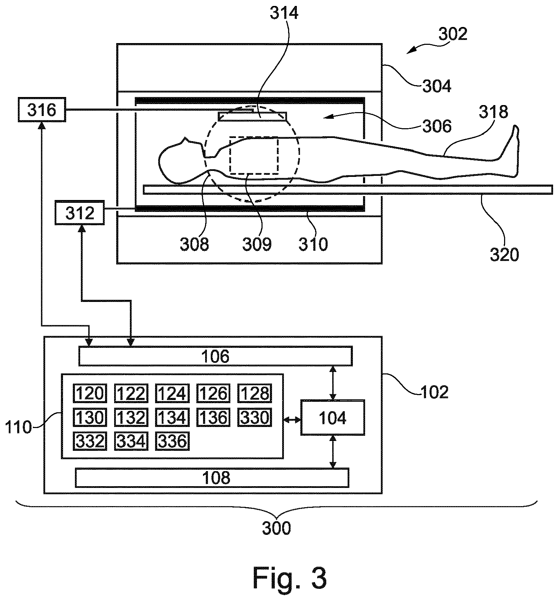

Fig. 3 illustrates a further example of a medical system 300. The medical system 300 depicted in Fig. 3 is similar to the medical system 100 depicted in Fig. 1 except that it additionally comprises a magnetic resonance imaging system 302 that is controlled by the computational system 104.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data that is acquired typically acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for acquisition of preliminary k-space data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise, the transceiver 316 may also represent a separate transmitter and receivers. The radio-frequency coil 314 may also have multiple receive/transmit elements and the radio frequency transceiver 316 may have multiple receive/transmit channels.

The transceiver 316 and the gradient controller 312 are shown as being connected to the hardware interface 106 of the computer system 102. Both of these components, as well as others such as the subject support supplying positional data, may supply the sensor data 126.

The memory 110 is further shown as containing a Bloch simulator. The memory 110 is further shown as containing an MRF dictionary 332. The MRF dictionary 332 may be constructed by controlling the Bloch simulator 330 with the selected MRF pulse sequence 136. The memory 110 is further shown as containing MRF k-space data 334 that has been acquired by controlling the magnetic resonance imaging system 302 with the selected MRF pulse sequence 136. The memory 110 is further shown as containing an MRF image 336 that has been reconstructed from the MRF k-space data 334 using the MRF dictionary 332.

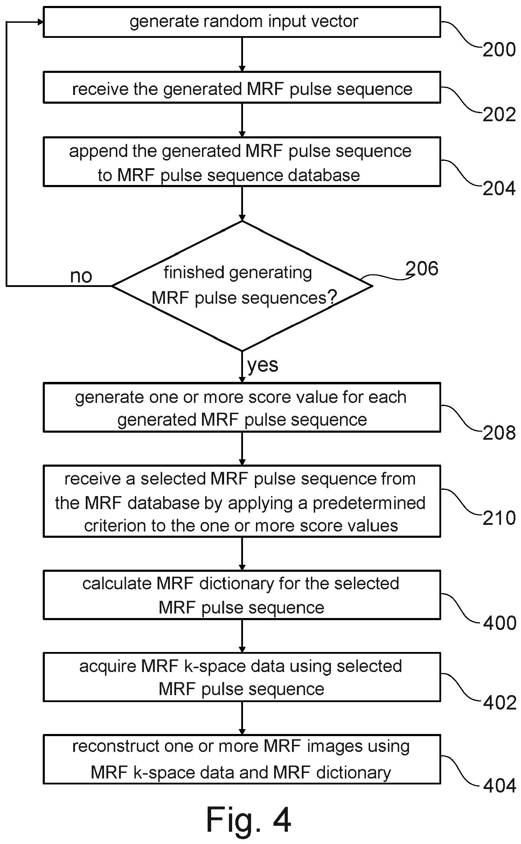

Fig. 4 shows a flowchart which illustrates a method of operating the medical system 300 of Fig. 3. The method depicted in Fig. 4 is similar to the method depicted in Fig. 2 with additional steps that are performed. The method depicted in Fig. 4 contains steps 200-210 as was depicted in Fig. 2. After step 210, step 400 is additionally performed. In step 400 the MRF dictionary 332 is calculated by controlling the Bloch simulator 330 with the selected MRF pulse sequence 136. Next, in step 402, the MRF k-space data 334 is acquired by controlling the magnetic resonance imaging system 302 with the selected MRF pulse sequence 136. Finally, in step 404, one or more MRF images 336 are reconstructed using the MRF k-space data 334 and the MRF dictionary 332.

MR Fingerprinting (MRF) is a relatively new method for quantitative MRI. Multiple quantitative parameters are encoded simultaneously in a transient signal evolution, by employing a train of RF pulses with varying properties (flip angle, phase, timing, spoiling, etc.). MRF sequences typically consist of hundreds of RF pulses, leading to a huge parameter space of hundreds or even thousands of dimensions. Finding an optimized MRF sequence is therefore a difficult task.

Generative Adversarial Networks (GANs) are a relatively new AI technology that are very good at synthesizing realistic new datasets from a given set. There are impressive examples on the web showing examples of cartoon character and photo generation.

A GAN consists of a generator and a discriminator network. The generator generates data based on what the discriminator flags as real or not. The discriminator flags data as right or wrong based on learning from the real data. The training of the two networks happens alternatingly, so they each get better at generating and discriminating gradually and (ideally) at the same pace.

Examples may facilitate the synthesis of optimized MRF sequences from a set of known ones through the use of a Generative Adversarial Network (GAN).

Examples may contain one or more of the following features:
- A set of known useful MR fingerprinting sequence parameters.
- A GAN synthesizing a new sequence.
- An AI algorithm scoring the quality of fingerprinting sequence.
- A method to select GAN-synthesized MRF sequences based on AI predictions of quality scores

Examples may use a GAN to synthesize optimized fingerprinting sequences from a set of known good ones. A metric for the quality of the MRF sequence needs to be defined. Typically, such a metric would consider how well different regions in the quantitative parameter space can be distinguished. The exact definition of the quality metric is not important for this implementation. The GAN-synthesized sequences will by design qualify as suitable fingerprinting sequences. The question is if they are also good ones. In order to judge how good a generated sequence is, we propose to implement another AI network that is trained to score a sequence. This second network can be trained from already existing fingerprint sequences that have been scored.

With this framework, a virtually infinite number of sequences can be generated and scored. The best scored sequences can be tried out in practice. If they prove to be good, they can again be integrated into the discriminator training dataset.

Scoring an MRF sequence can be a very computation intensive task. Typically, a large number of signals for different parameters (T1, T2, B1, B0, etc.) need to be calculated in order to determine the coding efficiency in different regions of the parameter space. If a large number of MRF sequences should be evaluated, this procedure can take considerable time.

Examples may use an AI algorithm (e.g., a neural network, trained scoring algorithm 124) for quality scoring (providing one or more score values 132). In this way, the scoring can be realized much faster to enable a quick search through a large number of MRF sequences to find the optimum.

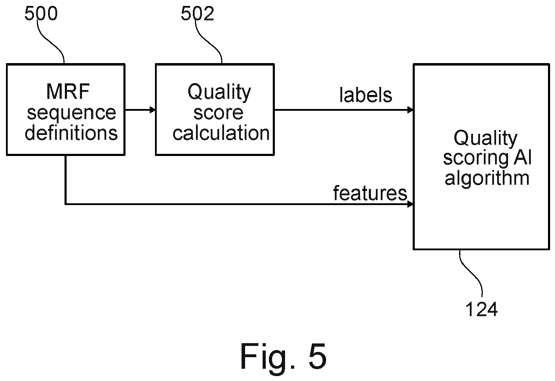

The training process of this algorithm is shown in Fig. 5. For a number of MRF sequence definition, a quality score is calculated. The AI algorithm is trained on the MRF sequence definitions as features and the respective quality scores as labels. After training, the AI algorithm will be able to predict a quality score for an unknown MRF sequence definition.

Fig. 5 shows a flowchart which illustrates the training of the trained scoring algorithm 124, which is also referred to as the quality scoring AI algorithm. Using a supervised learning, the MRF sequence definitions 500 are input into a quality score calculation 502 and into the quality scoring algorithm 124. The results of the quality score calculation 502 are also input into the quality scoring AI algorithm 124. The MRF sequence definitions 500 provide the features and the quality score calculation 502 provides the labels for the supervised learning. Pulse sequences are essentially timing diagrams. The MRF sequence definitions 500 may be used to define parameters of a timing sequence that is used to make an MRF acquisition.

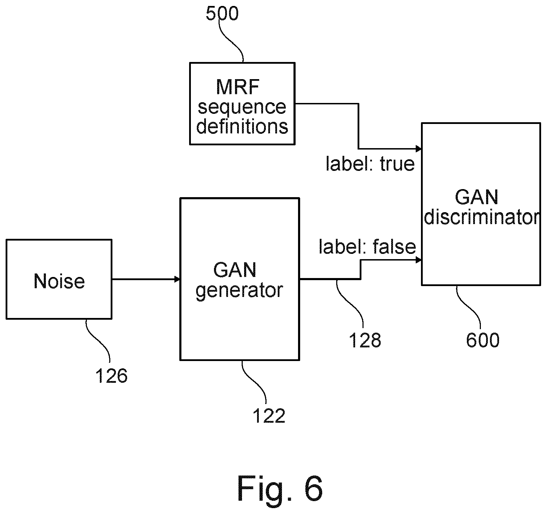

Fig. 6 illustrates the training of the GAN generator neural network 122 or is also referred to simply as the GAN generator. The GAN generator 122 is paired with the GAN discriminator 600. A noise vector 126 is input into the GAN generator 122 and this generates a generated MRF pulse sequence 128. The GAN discriminator 600 is trained to learn the difference between the MRF sequence definitions 500 and the generated MRF pulse sequences 128. By alternating training the GAN generator 122 and the GAN discriminator 600 they both perform increasingly well until the GAN generator 122 is able to generate suitable MRF pulse sequences.

A Generative Adversarial Network (GAN) is trained to generate MRF sequences that resemble known MRF sequences of good encoding quality. A GAN consists of a discriminator network and a generator network. Both are trained in an iterative procedure as shown in Fig. 6. The generator is fed with noise to create a random sequence definition. The discriminator is trained to distinguish such a "false" MRF sequence from the "true" ones provided for training. By iteratively optimizing the weights of the two networks, the generator learns to generate MRF sequences that have similar properties as the known ones.

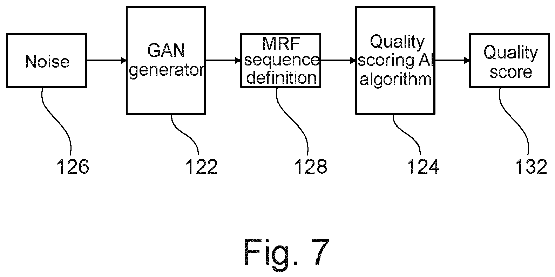

Fig. 7 illustrates one use of the GAN generator neural network 122 during deployment. In this flowchart the random input vector 126 is input into the GAN generator 122. This then provides the generated MRF pulse sequence 128 which is input into the trained scoring algorithm 124. The trained scoring algorithm 124 then provides the one or more score values 132. The one or more score values 132 can be used for example as the predetermined criterion 134 to select whether the generated MRF pulse sequence 128 is used or not.

The trained networks (GAN generator and quality scoring algorithm) are then used in a sequential setup as indicated in Fig. 7. In a first step, the GAN generator creates a new MRF sequence from noise input. In a second step, the quality scoring AI algorithm predicts a quality score for this sequence. After repeating this process many times, the MRF sequence(s) with the best quality score(s) is/are selected as optimized MRF sequence.

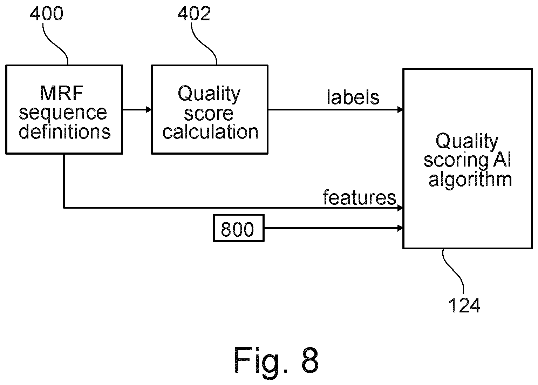

Fig. 8 illustrates an extension of the trained scoring algorithm 124 illustrated in Fig. 4. In the example illustrated in Fig. 7 additionally one or more control switch 800 is input as an additional feature. The one or more control switch 800 is used to encode such things as the anatomical region being imaged, details about the subject, and even possibly the clinical question. This enables the trained scoring algorithm 124 to be configured or adjusted to particular acquisition conditions.

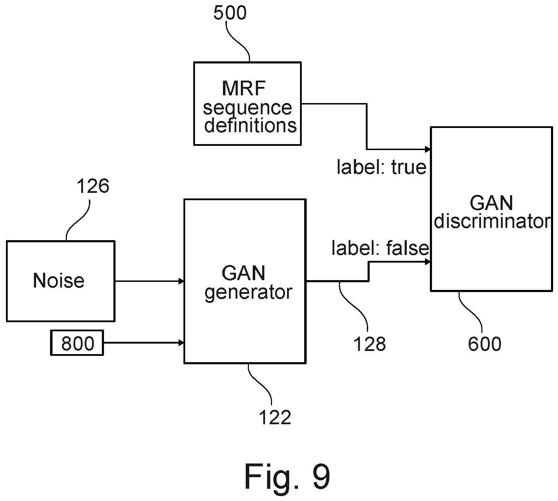

Fig. 9 illustrates a modification of the GAN generator neural network 122 illustrated in Fig. 5. In this example, in addition to a random input vector 126, the one or more control switch 700 is also input into the GAN generator. The addition of the one or more control switch 800 to the GAN generator 122 during training enables the behavior of the GAN generator to be controlled or configured. As was mentioned previously, the one or more control switch 800 could be used to encode such things as the anatomy being imaged, the clinical question, or details about the subject being imaged.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: computer
- 104: computational system
- 106: hardware interface
- 108: user interface
- 110: memory
- 120: machine executable instructions
- 122: GAN generator neural network
- 124: trained scoring algorithm
- 126: random input vector
- 128: generated MRF pulse sequence
- 130: MRF pulse sequence database
- 132: one or more score values
- 134: predetermined criterion
- 136: selected MRF pulse sequence
- 200: generate the random input vector
- 202: receive the generated MRF pulse sequence in response to inputting the random input vector into the GAN generator neural network
- 204: append the generated MRF pulse sequence to an MRF pulse sequence database
- 208: input each generated MRF pulse sequence in the MRF pulse sequence database into the trained scoring algorithm to assign the one or more score values to each generated MRF pulse sequence
- 210: receive a selected MRF pulse sequence from the MRF pulse sequence database by applying a predetermined criterion to the one or more score values of each generated MRF pulse sequence in the MRF pulse sequence database
- 300: medical system
- 302: magnetic resonance imaging system
- 304: magnet
- 306: bore of magnet
- 308: imaging zone
- 309: field of view
- 310: magnetic field gradient coils
- 312: magnetic field gradient coil power supply
- 314: radio-frequency coil
- 316: transceiver
- 318: subject
- 320: subject support
- 330: Bloch simulator
- 332: MRF dictionary
- 334: MRF k-space data
- 336: MRF image
- 400: calculate an MRF dictionary with predetermined dictionary entries for the selected MRF pulse sequence by performing a Bloch equation simulation controlled by the selected MRF pulse sequence for each of the predetermined dictionary entries
- 402: acquire (402) MRF k-space data by controlling the magnetic resonance imaging system
- 404: reconstruct (404) one or more MRF images using the MRF k-space data and the MRF dictionary
- 500: MRF sequence definition
- 502: Quality score calculation
- 600: GAN discriminator
- 800: one or more control switch

## Claims

1. A medical system (100, 300) comprising:
- a memory (110) storing machine executable instructions (120), a GAN generator neural network (122), and a trained scoring algorithm (124), wherein the GAN generator neural network is configured to output a generated MRF pulse sequence (128) in response to receiving a random input vector (126), wherein the trained scoring algorithm is configured to output one or more score values (132) in response to receiving the generated MRF pulse sequence as input;
- a computational system (104), wherein execution of the machine executable instructions causes the computational system to repeatedly:
- generate (200) the random input vector;
- receive (202) the generated MRF pulse sequence in response to inputting the random input vector into the GAN generator neural network; and
- append (204) the generated MRF pulse sequence to an MRF pulse sequence database (130);
wherein execution of the machine executable instructions causes the computational system to:
- input (208) each generated MRF pulse sequence in the MRF pulse sequence database into the trained scoring algorithm to assign the one or more score values to each generated MRF pulse sequence; and
- receive (210) a selected MRF pulse sequence (136) from the MRF pulse sequence database by applying a predetermined criterion (134) to the one or more score values of each generated MRF pulse sequence in the MRF pulse sequence database.

2. The medical system of claim 1, wherein execution of the machine executable instructions further causes the computational system to calculate (400) an MRF dictionary (332) with predetermined dictionary entries for the selected MRF pulse sequence by performing a Bloch equation simulation controlled by the selected MRF pulse sequence for each of the predetermined dictionary entries.

3. The medical system of claim 2, wherein the medical system further comprises a magnetic resonance imaging system (302), wherein execution of the machine executable instructions further causes the computational system to:
- acquire (402) MRF k-space data (334) by controlling the magnetic resonance imaging system with the selected MRF pulse sequence, and
- reconstruct (404) one or more MRF images (336) using the MRF k-space data and the MRF dictionary.

4. The medical system of any one of the preceding claims, wherein the GAN generator neural network is further configured to receive one or more control switches (800) as input, wherein execution of the machine executable in instructions further causes the computational system to:
- receive the one or more control switches;
- input the one or more control switches into the GAN generator neural network with the random input vector; and
- store the one or more control switches with the generated MRF pulse sequence in the MRF pulse sequence database, wherein the selected MRF pulse sequence is at least partially chosen using a set of chosen control switches.

5. The medical system of claim 4, wherein the one or more control switches comprise any one of the following: an anatomical region, a clinical question, a timing restriction, a breath hold duration and combinations thereof.

6. The medical system of any one of the preceding claims, wherein choosing the selected MRF pulse sequence from the MRF pulse sequence database by applying a predetermined criterion to the one or more score values of each generated MRF pulse sequence in the MRF pulse sequence database comprises:
- calculating a composite score using the one or more score value; and
- selecting the generated MRF pulse sequence with the highest composite score as the selected MRF pulse sequence.

7. The medical system of claim 6, wherein execution of the machine executable instructions further causes the computational system to:
- receive user input, wherein the user input specifies a composition of the composite score, and wherein the selected MRF pulse sequence is chosen in response to receiving the user input.

8. The medical system of any one of claims 1 to 5, wherein choosing the selected MRF pulse sequence from the MRF pulse sequence database comprises:
- selecting a subset of MRF pulse sequences from the MRF pulse sequence database that meet a screening criterion;
- calculating a set of numerically calculated score values for each of the subset of MRF pulse sequences;
- choosing the selected MRF pulse sequence from the subset of MRF pulse sequences by comparing the predetermined criterion to the set of numerically calculated score values for each of the subset of MRF pulse sequences.

9. The medical system of any one of the preceding claims, wherein the one or more score values comprises any one of the following: a T1 accuracy score, a T2 accuracy score, a T2-star accuracy score, a proton density accuracy score, and combinations thereof.

10. The medical system, in particular of any one of the preceding claims, wherein execution of the machine executable instructions further causes the computational system to:
- receive a training MRF pulse sequence; and
- train the GAN generator neural network and a GAN discriminator neural network (600) using the training MRF pulse sequence according to a GAN training protocol.

11. The medical system of any one of the preceding claims, wherein execution of the machine executable instructions further causes the computational system to:
- receive a prior MRF pulse sequence;
- calculate a set of numerically evaluated score values for each of the one or more score values for the prior MRF pulse sequence; and
- train the trained scoring algorithm using the prior MRF pulse sequence and the set of numerically evaluated score values.

12. The medical system of any one of the preceding claims, wherein the trained score algorithm is implemented as any one of the following: a decision tree, a support vector machine, a multilayer perceptron neural network, a ResNET neural network, a convolutional neural network, and a U-Net neural network.

13. A computer program comprising machine executable instructions (120) for execution by a computational system (104), wherein execution of the machine executable instructions causes the computational system to repeatedly:
- generate (200) a random input vector (126);
- receive (202) a generated MRF pulse sequence in response to inputting the random input vector into a GAN generator neural network (122), wherein the GAN generator neural network is configured to output the generated MRF pulse sequence in response to receiving the random input vector; and
- append (204) the generated MRF pulse sequence to an MRF pulse sequence database (130);
wherein execution of the machine executable instructions causes the computational system to:
- input (208) each generated MRF pulse sequence in the MRF pulse sequence database into a trained scoring algorithm (124) to assign the one or more score values (132) to each generated MRF pulse sequence, wherein the trained scoring algorithm is configured to output the one or more score values in response to receiving the generated MRF pulse sequence as input; and
- receive (210) a selected MRF pulse sequence (136) from the MRF pulse sequence database by applying a predetermined criterion (134) to the one or more score values of each generated MRF pulse sequence in the MRF pulse sequence database.

14. A method, wherein the method comprises repeatedly:
- generating (200) a random input vector (126);
- receiving (202) a generated MRF pulse sequence (128) in response to inputting the random input vector into a GAN generator neural network (122), wherein the GAN generator neural network is configured to output the generated MRF pulse sequence in response to receiving the random input vector; and
- appending (204) the generated MRF pulse sequence to an MRF pulse sequence database; wherein the method further comprises:
- inputting (208) each generated MRF pulse sequence in the MRF pulse sequence database into a trained scoring algorithm (124) to assign one or more score values (132) to each generated MRF pulse sequence, wherein the trained scoring algorithm is configured to output the one or more score values in response to receiving the generated MRF pulse sequence as input; and
- receiving (210) a selected MRF pulse sequence (136) from the MRF pulse sequence database by applying a predetermined criterion (134) to the one or more score values of each generated MRF pulse sequence in the MRF pulse sequence database.

15. A method of computer implemented training of a scoring algorithm (124) for a GAN generator neural network (122), that is configured to output a generated MRF pulse sequence (128) in response to receiving a random input vector (126), and wherein the trained scoring algorithm is configured to output one or more score values (132) in response to receiving the generated MRF pulse sequence as input to train the GAN generator neural network and a GAN discriminator neural network (600) using the training MRF pulse sequence according to a GAN training protocol.
